# EUROPEAN PATENT APPLICATION

(11) **EP 1 175 054 A1**
(43) Date of publication of application: **23.01.2002**
(21) Application number: 01906176.1
(22) Date of filing: 21.02.2001
(51) Int. Cl.: H04L 27/00, H04J 13/00

(54) **RECEIVER**

(30) Priority: 24.02.2000 JP 2000048094
(71) Applicant: MITSUBISHI DENKI KABUSHIKI KAISHA, Tokyo 100-8310 (JP)
(72) Inventor: SUZUKI, Takeo, c/o Mitsubishi Denki K. K., Chiyoda-ku, Tokyo 100-83 10 (JP); ISHIOKA, Kazuaki, c/o Mitsubishi Denki K.K., Chiyoda-ku, Tokyo 100-8310 (JP)
(74) Representative: Pfenning, Meinig & Partner GbR
(86) International application number: JP0101262
(87) International publication number: WO0163867

(57) **Abstract**

The present invention provides a receiver including: A/D converters (1-1 to 1-4) for converting receiving analog signals (I1, Q1, I2, Q2) into digital signals; a quantizing error reduction signal generator (2) for generating a random noise quantizing error reduction; adders (3-1 to 3-4) for adding the converted digital signal and the quantizing error reduction signal; bit shift circuits (4-1 to 4-4) for reducing a bit number of addition; low-pass filters (5-1, 5-2) for removing a quantizing error reduction signal included in the digital signal having a reduced bit number; matched filters (6-1, 6-2); and a demodulation section (7).

## Description

### TECHNICAL FIELD

The present invention relates to a receiver used for various communication systems including a mobile communication system and a satellite communication system.

### BACKGROUND ART

Conventionally, a receiver used for various communication systems has an A/D converter for converting an analog receiving signal into a digital signal with the advance of recent digitizing technology. In the A/D conversion, the more a bit number (count) of the converted digital signal increases, the more a resolution improves. However, in this case, a circuit scale of receiver becomes large, and further, power consumption is increased. For this reason, the bit number of the converted digital signal is reduced, and thereby, it is possible to achieve a reduction of the circuit scale and power consumption. However, the bit number is reduced, and thereby, a quantizing error of the digital signal increases; as a result, a problem arises such that signal detection accuracy is deteriorated.

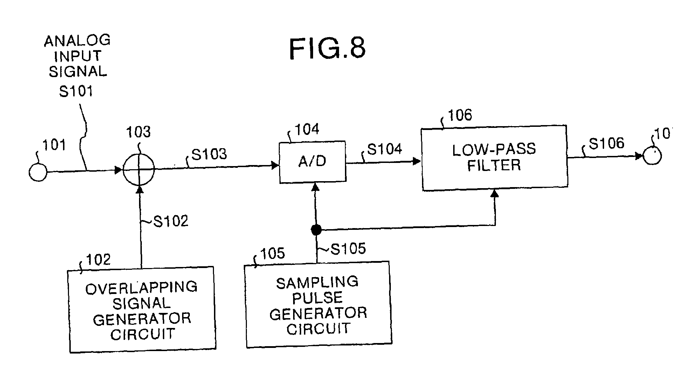

In this case, an A/D converter circuit has been known such that an overlapping signal is added to the analog receiving signal so as to reduce a quantizing error in the A/D conversion (see Japanese Patent Application Laid-Open No. 8-228152). Fig. 8 is a block diagram showing a configuration of the A/D converter circuit. In Fig. 8, an overlapping signal generator circuit 102 generates a constant amplitude overlapping signal S102 having a frequency, which is less than 1/2 times of a sampling pulse S105 generated by a sampling pulse generator circuit 105, and is higher than the maximum frequency of an analog input signal S101. An adder 103 adds the overlapping signal S102 to the analog input signal S101, and then, inputs an added signal S103 to an A/D converter 104. The A/D converter 104 converts the signal S103 into a digital signal S104 based on the sampling pulse S105, and then, outputs it. A low-pass filter 106 outputs a digital signal S106 attenuating the overlapping signal S102 component of the input digital signal S104.

In the A/D converter circuit, the overlapping signal S102 is added to the A/D-converted analog input signal, and thereby, a quantizing error is reduced in the A/D conversion.

However, even if the above A/D converter circuit is applied to a general receiver, if the bit number of the digital signal after A/D conversion is reduced, and thereafter, digital signal processing is performed, it is impossible to reduce the quantizing error due to the reduction of the bit number. As a result, a problem arises such that signal detection accuracy is deteriorated.

Further, the overlapping signal S102 input to the adder 103 of the above A/D converter circuit is an analog signal; for this reason, there is a problem that each circuit scale of the overlapping signal generator circuit 102 and the adder 103 becomes large. As a result, it is impossible to achieve a reduction of circuit scale and power consumption in the entirety of receiver.

It is, therefore, an object of the present invention to provide a receiver, which can output a digital signal reducing a quantizing error even if a bit number of digital signal generated by an A/D conversion is modified, and can reduce a circuit scale and power consumption by modifying the bit number, in particular, reducing the bit number.

In order to achieve the above object, the present invention provides a receiver which comprises at least one A/D converter which converts received analog signal into a digital signal; a reduction signal generator which generates a random noise quantizing error reduction signal for reducing a quantizing error of the digital signal converted by the A/D converter; at least one adder which adds the digital signal and the quantizing error reduction signal generated by the reduction signal generator; at least one bit number modifier which modifies a bit number of an addition signal added by the adder; and at least one low-pass filter which removes a quantizing error reduction signal included in the digital signal having a bit number modified by the bit number modifier.

According to the above-mentioned invention, the adder adds the digital signal output from the A/D converter and the quantizing error reduction signal output from the reduction signal generator, and the bit number modifier modifies the bit number, for example, reduces the bit number. The quantizing error reduction signal is added to the digital signal, and thereby, a correlation is offset between the receiving digital signal and quantizing error generated by the modification of bit number. Therefore, it is possible to prevent a signal deterioration due to quantizing generated by the modification of bit number. Further, the added quantizing error reduction signal is removed by the low-pass filter.

Furthermore, the present invention provides a receiver which comprises at least one A/D converter which converts a spread spectrum received analog signal into a digital signal; a reduction signal generator which generates a random noise quantizing error reduction signal for reducing a quantizing error of the digital signal converted by the A/D converter; at least one adder which adds the digital signal and the quantizing error reduction signal generated by the reduction signal generator; at least one bit number modifier which modifies a bit number of an addition signal added by the adder; at least one de-spread unit which de-spreads the digital signal having a bit number modified by the bit number modifier; and at least one integral processing unit which integrates the digital signal de-spread by the de-spread unit.

According to the above-mentioned invention, even if the receiving analog signal is a spread spectrum signal, the adder adds the digital signal output from the A/D converter and the quantizing error reduction signal output from the reduction signal generator, and the bit number modifier modifies the bit number, for example, reduces the bit number. The quantizing error reduction signal is added to the digital signal, and thereby, a correlation is offset between the receiving digital signal and quantizing error generated by the modification of bit number. Therefore, it is possible to prevent a signal deterioration due to quantizing generated by the modification of bit number. Further, the added quantizing error reduction signal is securely removed by integral equalization effect by the de-spread unit and integral processing unit.

Furthermore, in the receiver, the quantizing error reduction signal gene rated by the reduction signal generator is a triangular wave signal.

According to the above-mentioned invention, the quantizing error reduction signal generated by the reduction signal generator is a triangular wave signal, and the triangular wave signal has a uniform distribution. Therefore, it is possible to interpolate and restore a signal component lost by the reduction of bit number. Further, the frequency characteristic of the triangular wave signal exists in a high frequency band, so that the quantizing error reduction signal can be readily removed. Furthermore, the triangular wave signal can be generated by a simple configuration.

Moreover, in the receiver, the quantizing error reduction signal generated by the reduction signal generator is a signal having an orthogonal code having an orthogonal relation with a spreading code used when the de-spread unit de-spreads an input digital signal.

According to the above-mentioned invention, the quantizing error reduction signal generated by the reduction signal generator is a signal having an orthogonal code, which has an orthogonal relation with a spreading code used in the case of de-spread a digital signal input to the de-spread unit. The quantizing error reduction signal is offset by de-spread of the de-spread unit and integral processing of the integral processing unit so that the quantizing error reduction signal can be readily removed.

Moreover, in the receiver, the quantizing error reduction signal generated by the reduction signal generator is a signal having a high frequency band as compared with a frequency band of the receiving analog signal.

According to the above-mentioned invention, the quantizing error reduction signal generated by the reduction signal generator is a signal having a high frequency band as compared with a frequency band of the digital signal, and the receiving digital signal and the quantizing error reduction signal are separated on the frequency axis.

Moreover, is the receiver, the quantizing error reduction signal generated by the reduction signal generator is a rectangular wave signal having a uniform distribution.

According to the above-mentioned invention, the quantizing error reduction signal generated by the reduction signal generator is a rectangular wave signal having a uniform distribution. Therefore, it is possible to more accurately interpolate and restore a signal component lost' by the uniform distribution of the rectangular wave signal and the reduction of bit number. Further, the rectangular wave signal is realized by a simple configuration.

Moreover, the receiver further comprises at least one matched filter, which is arranged on the pre-stage of the low-pass filter.

According to the above-mentioned invention, the matched filter is arranged on the pre-stage of the low-pass filter, and only when the matched filter makes an output operation, the low-pass filter is operated. Therefore, the number of operation times of low-pass filter is reduced.

### BRIEF DESCRIPTION OF THE DRAWINGS

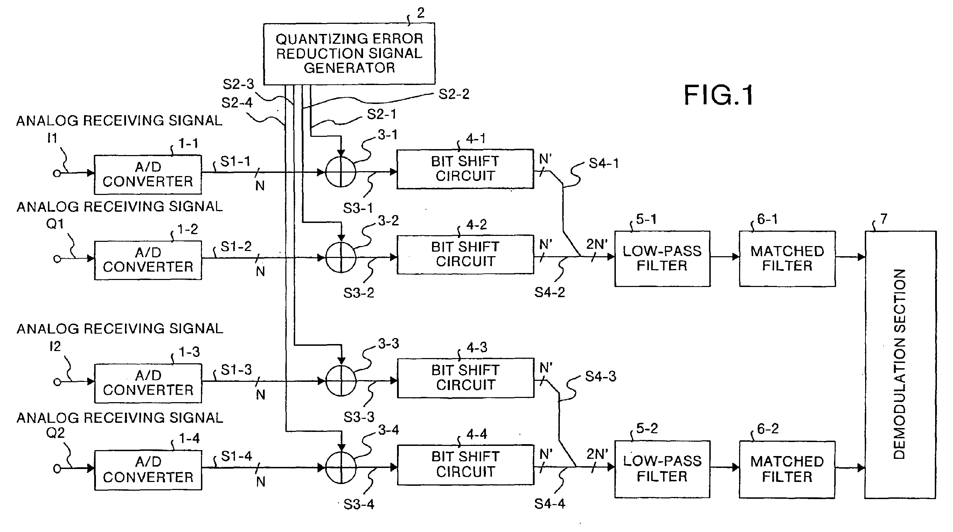

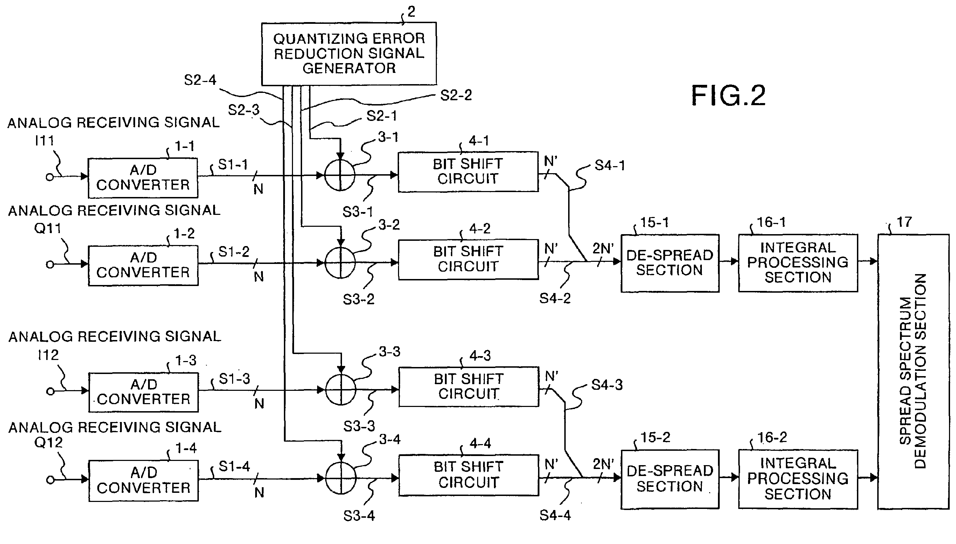

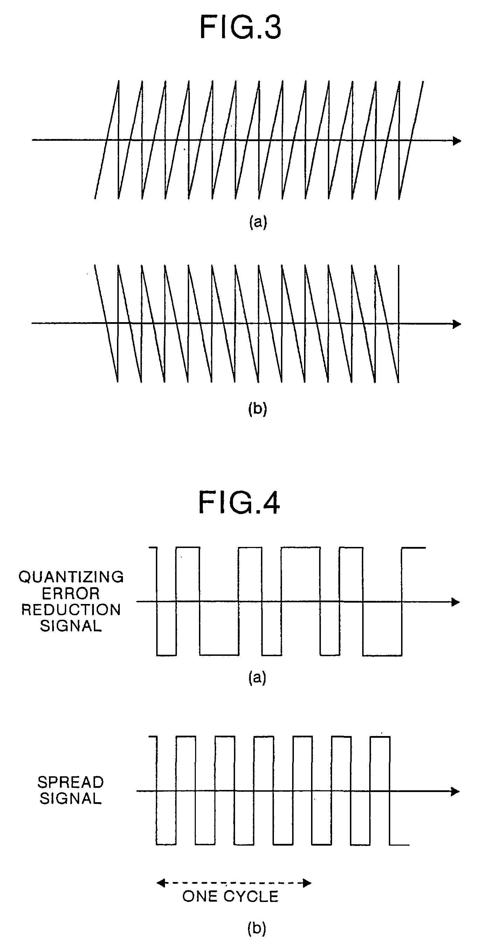

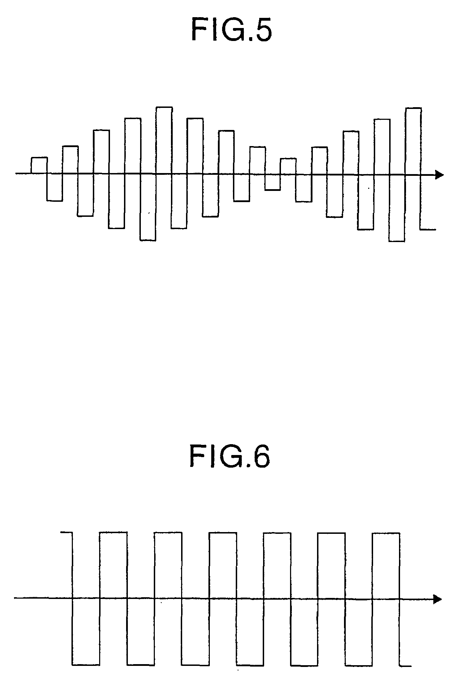

Fig. 1 is a block diagram showing a configuration of receiver according to a first embodiment of the present invention; Fig. 2 is a block diagram showing a configuration of receiver according to a second embodiment of the present invention; Fig. 3 is a waveform chart showing a quantizing error reduction signal generated by a receiver according to a third embodiment of the present invention; Fig. 4 is a waveform chart showing a quantizing error reduction signal generated by a receiver according to a fourth embodiment of the present invention; Fig. 5 is a waveform chart showing a quantizing error reduction signal generated by a receiver according to a fifth embodiment of the present invention; Fig. 6 is a waveform chart showing a quantizing error reduction signal generated by a receiver according to a sixth embodiment of the present invention; Fig . 7 is a block diagram showing a configuration of receiver according to a seventh embodiment of the present invention; and Fig. 8 is a block diagram showing a configuration of conventional A/D converter.

Embodiments of receiver according to the present invention will be explained in detail below with reference to the accompanying drawings.

### First Embodiment

Fig. 1 is a block diagram showing a configuration of receiver according to a first embodiment of the present invention. As shown in Fig. 1, analog receiving signals I1, Q1 I2 and Q2 orthogonally separated for each branch are input into A/D converters 1-1 to 1-4, and thereafter, are converted into N bit, for example, 16 bit digital signals S1-1 to S1-4, respectively. These digital signals S1-1 to S1-4 are input individually into adders 3-1 to 3-4.

A quantizing error reduction signal generator 2 inputs quantizing error reduction signals S2-1 to S2-4 for reducing a quantizing error with respect to each of the adders 3-1 to 3-4. Each of these quantizing error reduction signals S2-1 to S2-4 is a digital random noise signal, for example. Further, these quantizing error reduction signals S2-1 to S2-4 may. be the same signal or different signal.

The adders 3-1 to 3-4 add the digital signals S1-1 to S1-4 output from the A/D converters 1-1 to 1-4 and the quantizing error reduction signals S2-1 to S2-4, and then, output the added digital signals S3-1 to S3-4 to bit shift circuits 4-1 to 4-4, respectively. The bit shift circuits 4-1 to 4-4 reduces each bit number N of the input digital signals S3-1 to S3-4 to a bit number N' (N'<N). For example, 16-bit digital signals S3-1 to S3-4 are individually reduced to 12-bit digital signal. The digital signals S4-1 to S4-4 thus reduced are input to low-pass filters 5-1 and 5-2 for each branch. In other words, for each branch, a 2N'-bit digital signal is input to each of the low-pass filters 5-1 and 5-2.

The low-pass filters 5-1 and 5-2 restore and output a digital signal before reducing the bit number by the bit shift circuits 4-1 to 4-4 and removing the quantizing error reduction signals S2-1 to S2-4. Matched filters 6-1 and 6-2 control each phase of the digital signals output from the low-pass filters 5-1 and 5-2, and then, output it to a demodulation section 7. The demodulation section 7 performs demodulation processing with respect to each branch based on a signal output from each of the matched filters 6-1 and 6-2.

According to the first embodiment, even if there exists a non-observable signal due to the reduction of bit number made by the bit shift circuits 4-1 to 4-4, it is possible to maintain signal detection accuracy before the reduction of bit number from the following reason. More specifically, by the adders 2-1 to 2-4, the quantizing error reduction signal S2-1 to S2-4 are added to the digital signals S1-1 to S1-4, and thereby, a correlation is offset between the digital signals S1-1 to S1-4 and a quantizing error generated by the reduction of bit number. As a result, signal deterioration by quantizing can be prevented. Further, the bit number is reduced, and thereby, it is possible to prevent a deterioration of signal detection accuracy by the reduction of bit number, and to realize a reduction of circuit scale of the entirety of receiver and a reduction of power consumption.

### Second Embodiment

The second embodiment of the present invention will be described below. According to the second embodiment, it is possible to effectively reduce a quantizing error generated by the reduction of bit number of a receiver used for a spread spectrum communication system.

Fig. 2 is a block diagram showing a configuration of receiver according to a second embodiment of the present invention. As shown in Fig. 2, analog receiving signals I11, Q11, I12 and Q12 orthogonally separated and spectrum-spread for each branch are input into A/D converters 1-1 to 1-4, and thereafter, are converted into N-bit, for example, 16-bit digital signals S1-1 to S1-4, respectively. These digital signals S1-1 to S1-4 are input into adders 3-1 to 3-4, respectively.

A quantizing error reduction signal generator 2 inputs quantizing error reduction signals S2-1 to S2-4 for reducing a quantizing error with respect to each of the adders 3-1 to 3-4. Each of these quantizing error reduction signals S2-1 to S2-4 is a digital random noise signal, for example. Further, these quantizing error reduction signals S2-1 to S2-4 may be the same signal or different signal.

The adders 3-1 to 3-4 add the digital signals S1-1 to S1-4 output from the A/D converters 1-1 to 1-4 and the quantizing error reduction signals S2-1 to S2-4, and then, output the added digital signals S3-1 to S3-4 to bit shift circuits 4-1 to 4-4, respectively. The bit shift circuits 4-1 to 4-4 reduces each bit number N of the input digital signals S3-1 to S3-4 to a bit number N' (N'<N). For example, 16-bit digital signals S3-1 to S3-4 are individually reduced to 12-bit digital signal. In this case, even if there exists a non-observable signal due to the reduction of bit number made by the bit shift circuits 4-1 to 4-4, by the adders 2-1 to 2-4, the quantizing error reduction signal S2-1 to S2-4 are added to the digital signals S1-1 to S1-4. By doing so, a correlation is offset between the digital signals S1-1 to S1-4 and a quantizing error generated by the reduction of bit number; as a result, signal deterioration by quantizing can be prevented. The reduced digital signals S4-1 to S4-4 are input into de-spread sections 15-1 and 15-2 for each branch. In other words, 2N'-bit digital signals are input individually into the de-spread section 15-1 and 15-2 for each branch.

The de-spread sections 15-1 and 15-2 multiply the input digital signals by a spreading code such as PN code used in a transmitter side so as to perform de-spread. Subsequently, the integral processing sections 16-1 and 16-2 make a correlation, and then, output the correlation result to a spread spectrum demodulation section 17. In the correlation processing, a quantizing error reduction signal included in the digital signal is removed and equalized by integrating; as a result, it is possible to restore a signal corresponding to the digital signal before reducing the bit number and removing the quantizing error reduction signals S2-1 to S2-4. The spread spectrum demodulation section 17 performs a demodulation with respect to each branch based on each signal output from the integral processing sections 16-1 and 16-2.

This second embodiment relates to a receiver used for spread spectrum communication. Even if there exists a non-observable signal due to the reduction of bit number by the bit shift circuits 4-1 to 4-4, by the adders 2-1 to 2-4, the quantizing error reduction signal S2-1 to S2-4 are added to the digital signals S1-1 to S1-4. By doing so, it is possible to maintain signal detection accuracy before the reduction of bit number. Further, the bit number is reduced, and thereby, it is possible to prevent a deterioration of signal detection accuracy by the reduction of bit number while realizing a reduction of circuit scale of the entirety of receiver and a reduction of power consumption.

### Third Embodiment

The third embodiment of the present invention will be descried below. In the above the first embodiments and the second embodiment, the quantizing error reduction signals S2-1 to S2-4 are a random noise signal. In this third embodiment, the quantizing error reduction signals S2-1 to S2-4 are a triangular wave signal.

In this third embodiment, the quantizing error reduction signal generator 2 generates a triangular wave signal as shown in Fig. 3, and inputs the generated signal to each of the adders 3-1 to 3-4. Other configuration is the same as the first or second embodiment. In the triangular wave signal, a triangular waveform as shown in Fig. 3 is generated as a digital signal. The triangular wave signal may be a signal such that gradually increasing waveform is repeated as shown in Fig. 3(a), or may be a signal such that a gradually decreasing waveform is repeated as shown in Fig. 3(b). Further, the triangular wave signal may be a signal such that a combination of increasing and decreasing wave form is repeated. In this case, the triangular wave signal is generated by a simple circuit configuration. Thus, the triangular wave signal is generated by a simple configuration as compared with the case of generating a quantizing error reduction signal such as a random noise signal or the like.

The triangular wave signal has a feature such that a uniform distribution as compared with a quantizing error reduction signal such as a random noise signal or the like, and a frequency characteristic exists in a high frequency band (range) . The reason why the frequency characteristic exists in a high frequency band is because a waveform of the triangular wave is not smooth, and has a high frequency component.

The triangle wave signal has a uniform distribution. Therefore, it is possible to more securely restore and interpolate a signal component lost by the reduction of bit number. Further, the triangular wave signal exists in a high frequency band, and thereby, it is possible to securely remove a quantizing error reduction signal by the low-pass filters 5-1 and 5-2 of the first embodiment or the integral processing sections 16-1 and 16-2 of the second embodiment.

According to the third embodiment, the triangular wave signal is used as quantizing error reduction signal. Therefore, the receiver has a more simple circuit configuration as a whole . Further, The triangle wave signal has a uniform distribution. Therefore, it is possible to more securely restore and interpolate a quantizing error. Furthermore, the frequency characteristic exists in a high frequency band, and thereby, it is possible to securely remove a. quantizing error reduction signal.

### Fourth Embodiment

The fourth embodiment of the present invention will be described below. In the above second embodiment, the random noise signal has been used as the quantizing error reduction signal, and in the above third embodiment, the triangular wave signal has been used as the quantizing error reduction signal. In this fourth embodiment, an orthogonal signal having an orthogonal relation to the spread signal used in the de-spread sections 15-1 and 15-2 is used as the quantizing error reduction signals S2-1 to S2-4.

The fourth embodiment has the same configuration as the above second embodiment exclusive of a configuration of the quantizing error reduction signal generator 2. The quantizing error reduction signal generator 2 generates and outputs an orthogonal signal having an orthogonal relation to the spread signal used in the de-spread sections 15-1 and 15-2.

Fig. 4 (a) is a waveform chart showing one example of a quantizing error reduction signal used in third fourth embodiment. The quantizing error reduction signal shown in Fig. 4(a) has an orthogonal relation to a spread signal shown in Fig. 4(b). For example, one cycle of the spread signal shown in Fig. 4(b) has a value "-1, 1, -1, 1, -1, 1, -1, 1", the quantizing error reduction signal show in Fig. 4 (a) has a value "-1, 1, -1, -1, 1, -1, 1, 1" corresponding one cycle of the spread signal, and an inner product of the spread signal and the quantizing error reduction signal becomes zero. Therefore, the former and the latter have an orthogonal relation.

In this case, the quantizing error reduction signal having the orthogonal relation with the spread signal is offset by de-spread of the de-spread sections 15-1 and 15-2 and integral processing of the integral processing sections 16-1 and 16-2. Therefore, the quantizing error reduction signal can be securely removed. Incidentally, the orthogonal relation to the spread signal may be made with respect to one cycle of the spread signal, or a plurality of orthogonal signals having an orthogonal relation to partial signals in one cycle of the spread signal may be connected.

According to the fourth embodiment, the orthogonal code (signal) having the orthogonal relation with the spread signal is used as the quantizing error reduction signal. Therefore, it is possible to securely remove the quantizing error reduction signal.

### Fifth Embodiment

The fifth embodiment of the present invention will be described below. In this fifth embodiment, a signal having a high frequency exceeding the maximum frequency of digital signals S1-1 to S1-4 is used as the quantizing error reduction signal.

The fifth embodiment has the same configuration as the above first or second embodiment exclusive of a configuration of the quantizing error reduction signal generator 2. The quantizing error reduction signal generator 2 generates a signal having a high frequency exceeding the maximum frequency of digital signals S1-1 to S1-4. For example, the quantizing error reduction signal generator 2 generates a signal as shown in Fig. 5.

When the quantizing error reduction signal is a signal having a high frequency exceeding the maximum frequency of digital signals S1-1 to S1-4, the digital signals S1-1 to S1-4 and the quantizing error reduction signal is distributed in a state of separating from each other on a frequency axis. Therefore, the quantizing error reduction signal can be removed readily and securely by the low-pass filters 5-1 and 5-2 of the first embodiment or by the integral processing sections 16-1 and 16-2 of the second embodiment.

According to the fifth embodiment, the frequency of the quantizing error reduction signal is set to a high frequency exceeding the maximum frequency of digital signals S1-1 to S1-4. Therefore, the digital signals S1-1 to S1-4 and the quantizing error reduction signal are securely separated on the frequency axis . As a result, the quantizing error reduction signal can be removed readily and securely.

### Sixth Embodiment

The sixth embodiment of the present invention will be described below. In this sixth embodiment, a rectangular wave signal having a uniform distribution is used as the quantizing error reduction signal.

The sixth embodiment has the same configuration as the above first or second embodiment exclusive of a configuration of the quantizing error reduction signal generator 2. The quantizing error reduction signal generator 2 generates a rectangular wave signal having a uniform distribution as shown in Fig. 6. The rectangular wave signal shown in Fig. 6 is generated by a simple circuit configuration. Further, the rectangular wave signal shown in Fig. 6 has a uniform distribution. Therefore, it is possible to more accurately restore and interpolate a digital signal lost by the reduction of bit number.

According to the sixth embodiment, the rectangular wave signal having a uniform distribution is used as the quantizing error reduction signal. Therefore, the receiver has a more simple circuit configuration as a whole . Further, the rectangular wave signal shown has a uniform distribution. Therefore, it is possible to more securely interpolate and restore a quantizing error.

### Seventh Embodiment

The seventh embodiment of the present invention will be described below. In this seventh embodiment, the matched filters 6-1 and 6-2 are arranged on the pre-stage of the low-pass filters 5-1 and 5-2 of the first embodiment.

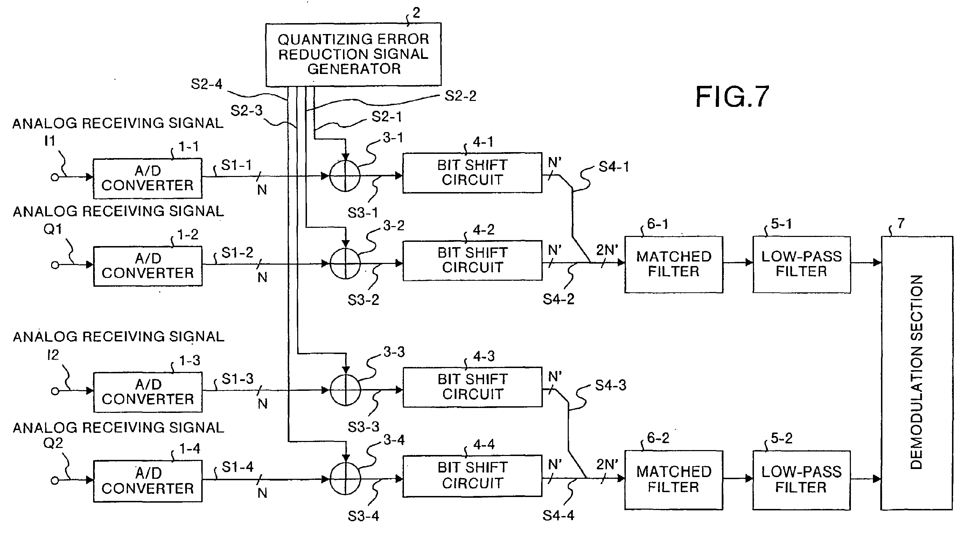

Fig. 7 is a block diagram showing a configuration of receiver according to a seventh embodiment of the present invention. The receiver shown in Fig. 7 has a configuration in which the low-pass filters 5-1 and 5-2 and the matched filters 6-1 and 6-2 are replaced in position. Other configuration is the same as the receiver shown in fig. 1.

In the above first embodiment, the low-pass filters 5-1 and 5-2 have been arranged on the pre-stage of the matched filters 6-1 and 6-2; for this reason, every when the signal is input into the matched filters 6-1 and 6-2, the low-pass filters 5-1 and 5-2 must be operated. On the contrary, in this seventh embodiment, the low-pass filters 5-1 and 5-2 are arranged on the after-stage of the matched filters 6-1 and 6-2. Therefore, only when these matched filters 6-1 and 6-2 make the output, the low-pass filters 5-1 and 5-2 may be operated. As a result, these low-pass filters 5-1 and 5-2 may perform the necessary and least operation. Therefore, the number of operation times of low-pass filters 5-1 and 5-2 is reduced, and thereby, it is possible to greatly reduce the power consumption of the entire receiver.

According to the seventh embodiment, the low-pass filters 5-1 and 5-2 have been arranged on the after-stage of the matched filters 6-1 and 6-2. Therefore, the low-pass filters 5-1 and 5-2 may perform the necessary and least operation, and it is possible to greatly reduce the power consumption of the entire receiver.

As is evident from the above description, according to the present invention, the adder adds the digital signal output from the A/D converter and the quantizing error reduction signal output from the reduction signal generator, and the bit number modifier modifies the bit number, for example, reduce the bit number. The quantizing error reduction signal is added to the digital signal, and thereby, a correlation is offset between the receiving digital signal and quantizing error generated by the modification of bit number. Therefore, it is possible to prevent a signal deterioration due to quantizing generated by the modification of bit number. Further, the added quantizing error reduction signal is removed by the low-pass filter. Therefore, even if the bit number is reduced, it is possible to prevent a deterioration of signal detection accuracy due to quantizing error. In addition, even if the bit number is reduced, it is possible to maintain signal detection accuracy equal to when the bit number is not reduced, so that therefore, the circuit scale can be made small, and power consumption can be reduced.

Further, according to the present invention, even if the receiving analog signal is a spread spectrum signal, the adder adds the digital signal output from the A/D converter and the quantizing error reduction signal output from the reduction signal generator, and the bit number modifier modifies the bit number, for example, reduces the bit number. The quantizing error reduction signal is added to the digital signal, and thereby, a correlation is offset between the receiving digital signal and quantizing error generated by the modification of bit number. Therefore, it is possible to prevent a signal deterioration due to quantizing generated by the modification of bit number. Further, the added quantizing error reduction signal is securely removed by integral equalization effect by the de-spread unit and integral processing unit. Therefore, even if the bit number is reduced, it is possible to prevent a deterioration of signal detection accuracy due to quantizing error. In addition, even if the bit number is reduced, it is possible to maintain signal detection accuracy equal to when the bit number is not reduced, so that the circuit scale can be made small, and power consumption can be reduced.

Further, according to the present invention, the quantizing error reduction signal generated by the reduction signal generator is a triangular wave signal, and the triangular wave signal has a uniform distribution. Therefore, it is possible to interpolate and restore a signal component lost by the reduction of bit number. Further, the frequency characteristic of the triangular wave signal exists in a high frequency band, so that the quantizing error reduction signal can be readily removed. Furthermore, the triangular wave signal can be generated by a simple configuration. Therefore, it is possible to prevent a deterioration of signal detection accuracy, and to realize the entire receiver with a simple configuration, so that the circuit scale can be made small, and power consumption can be reduced.

Further, according to the present invention, the quantizing error reduction signal generated by the reduction signal generator is a signal having an orthogonal code, which has an orthogonal relation with a spreading code used in the case of de-spread a digital signal input to the de-spread unit. The quantizing error reduction signal is offset by de-spread of the de-spread unit and integral processing of the integral processing unit, so that the quantizing error reduction signal can be readily removed. Therefore, it is possible to securely and readily remove the quantizing error reduction signal.

Further, according to the present invention, the quantizing error reduction signal generated by the reduction signal generator is a signal having a high frequency band as compared with a frequency band of the receiving digital signal, and the receiving digital signal and the quantizing error reduction signal are separated on the frequency axis. Therefore, it. is possible to securely and readily remove the quantizing error reduction signal.

Further, according to the present invention, the quantizing error reduction signal generated by the reduction signal generator is a rectangular wave signal having a uniform distribution. Therefore, it is possible to more accurately interpolate and restore a signal component lost by the uniform distribution of the rectangular wave signal and the reduction of bit number. Further, the rectangular wave signal is realized by a simple configuration. Therefore, it is possible to prevent a deterioration of signal detection accuracy, and to realize the entire receiver with a simple configuration, so that.the circuit scale can be made small, and power consumption can be reduced.

Further, according to the present invention, the matched filter is arranged on the pre-stage of the low-pass filter, and only when the matched filter makes an output operation, thelow-pass filter is operated. Therefore, the number of operation times of low-pass filter is reduced, so that the power consumption of the entire receiver can be reduced.

### INDUSTRIAL APPLICABILITY

As described above, the present invention is applicable to a receiver used for various communication systems including a mobile communication system and a satellite communication system. Even if the bit number of digital signal generated by A/D conversion is modified, it is possible to output a digital signal reducing a quantizing error, and the bit number is modified, in particular, the bit number is reduced, and thereby, it is effective to make small the circuit scale and to reduce power consumption.

## Claims

1. A receiver comprising:
at least one A/D converter which converts received analog signal into a digital signal;
a reduction signal generator which generates a random noise quantizing error reduction signal for reducing a quantizing error of the digital signal converted by the A/D converter;
at least one adder which adds the digital signal and the quantizing error reduction signal generated by the reduction signal generator;
at least one bit number modifier which modifies a bit number of an addition signal added by the adder; and
at least one low-pass filter which removes a quantizing error reduction signal included in the digital signal having a bit number modified by the bit number modifier.

2. The receiver according to claim 1, wherein the quantizing error reduction signal generated by the reduction signal generator is a triangular wave signal.

3. The receiver according to claim 1, wherein the quantizing error reduction signal generated by the reduction signal generator is a signal having a high frequency band as compared with a frequency band of the receiving analog signal.

4. The receiver according to claim 1, wherein the quantizing error reduction signal generated by the reduction signal generator is a rectangular wave signal having a uniform distribution.

5. The receiver according to claim 1, further comprising at least one matched filter, which is arranged on the pre-stage of the low-pass filter.

6. A receiver comprising:
at least one A/D converter which converts a receiving analog signal into a digital signal;
a reduction signal generator which generates a random noise quantizing error reduction signal for reducing a quantizing error of the digital signal converted by the A/D converter;
at least one adder which adds the digital signal and the quantizing error reduction signal generated by the reduction signal generator;
at least one de-spread unit which de-spreads the digital signal having a bit number modified by the bit number modifier; and
at least one integral processing unit which integrates the digital signal inverse infused by the de-spread unit.

7. The receiver according to claim 2, wherein the quantizing error reduction signal generated by the reduction 5 signal generator is a triangular wave signal.

8. The receiver according to claim 2, wherein the quantizing error reduction signal generated by the reduction signal generator is a signal having an orthogonal code having an orthogonal relation with a spreading code used when the de-spread unit de-spreads the input digital signal.

9. The receiver according to claim 2, wherein the quantizing error reduction signal generated by the reduction signal generator is a signal having a high frequency band as compared with a frequency band of the receiving analog signal.

10. The receiver according to claim 2, wherein the quantizing error reduction signal generated by the reduction signal generator is a rectangular wave signal having a uniform distribution.
